# EUROPÄISCHE PATENTSCHRIFT

(11) **EP 2 609 437 B1**
(45) Veröffentlichungstag und Bekanntmachung des Hinweises auf die Patenterteilung: **12.09.2018**
(21) Anmeldenummer: 11738678.9
(22) Anmeldetag: 14.07.2011
(51) Int. Cl.: G01R 31/36

(54) **VERFAHREN ZUM ERKENNEN EINES KRITISCHEN BATTERIEZUSTANDS NACH EINEM RÜCKSETZEN EINER BATTERIEÜBERWACHUNGSVORRICHTUNG**
METHOD FOR RECOGNISING A CRITICAL BATTERY CONDITION AFTER A RESET OF A BATTERY MONITORING DEVICE
PROCÉDÉ DE DÉTECTION D'UN ÉTAT DE BATTERIE CRITIQUE APRÈS LA RÉINITIALISATION D'UN DISPOSITIF DE SURVEILLANCE DE BATTERIE

(30) Priorität: 26.08.2010 DE 102010039785
(43) Veröffentlichungstag der Anmeldung: 03.07.2013
(73) Patentinhaber: Robert Bosch GmbH, 70442 Stuttgart (DE)
(72) Erfinder: KIZLER, Joachim, 70499 Stuttgart (DE); MOTZ, Juergen, 71711 Steinheim An Der Murr (DE)
(86) Internationale Anmeldenummer: PCT/EP2011/062026
(87) Internationale Veröffentlichungsnummer: WO 2012/025297

(56) Entgegenhaltungen:
- DE-A1-102007 026 144
- DE-B3-102004 033 836
- US-A- 5 698 965
- US-A- 5 739 670
- US-A1- 2010 174 498

## Beschreibung

Die vorliegende Erfindung betrifft Verfahren zum Erkennen eines kritischen Batteriezustands nach einem Rücksetzen einer Batterieüberwachungsvorrichtung.

### Stand der Technik

In modernen Kraftfahrzeugen werden verstärkt Vorrichtungen bzw. Systeme zur Überwachung der Starterbatterie eingesetzt. Ein beispielhaftes Verfahren zur Überwachung der Starterbatterie ist aus der DE 101 06 508 A1 bekannt.

Die US 5,698,965 A offenbart ein Ladungsmessgerät für eine Batterie, bei dem ein Abschaltsignal in einem nicht-flüchtigen Speicher gespeichert werden kann, wenn ein Ladezustand einer Batterie unter ein bestimmtes Niveau gefallen ist. Der Speicher ist mit einem Schalter für einen Verbraucher gekoppelt. Ist das Signal in dem Speicher, wird unterbunden, dass der Verbraucher Energie von der Batterie bezieht.

Von der Anmelderin wird eine Batterieüberwachungsvorrichtung unter der Bezeichnung "Elektronischer Batteriesensor (EBS)" angeboten. Dieser ist mit integrierter Auswerteelektronik ausgestattet und erfasst verschiedene Batteriegrößen wie Spannung, Strom und Temperatur, woraus mit Hilfe von Software-Algorithmen eine Anzahl von Größen, die den Zustand der Starterbatterie beschreiben, bestimmt werden.

Das Energiemanagement (EEM) moderner Fahrzeuge nutzt diese Informationen zielgerichtet, um bspw. die Ladung der Batterie zumindest soweit aufrecht zu erhalten, dass das Fahrzeug auch nach längerer Zeit sicher gestartet werden kann. Fließen die Informationen ins Management für den Generator und Motor ein, können sie den Kraftstoffverbrauch senken, damit den Schadstoffausstoß verringern und auch die Batterielebensdauer verlängern. Auch trifft das EEM basierend auf diesen Daten die Entscheidung, ob ein temporäres Abschalten des Motors im Rahmen eines Start/Stopp-Betriebs sinnvoll und möglich ist. Wesentlich sind hier die sog. Prädiktoren des EBS, welche dem EEM mitteilen, ob z.B. der Ladezustand der Batterie (State of Charge, SOC) ausreichend ist und ob der zu erwartende Spannungseinbruch beim nächsten Start (State of Function, SOF) vertretbar ist, so dass in Summe die Startfähigkeit des Fahrzeugs sichergestellt ist.

Wird die Batterieüberwachungsvorrichtung zurückgesetzt, bspw. durch einen veranlassten Reset oder durch (kurzzeitigen) Verlust einer ausreichenden Batteriespannungsversorgung bei entladener Batterie, muss sie den Batteriezustand anschließend alleine auf Grundlage der aktuellen Messwerte bestimmen. Diese Bestimmung kann jedoch durch verschieden Polarisationseffekte stark verfälscht sein, beispielsweise wenn die Batterie vor dem Reset stark entladen wurde oder bei Anwendung einer Fremdstartvorrichtung.

Es ist daher wünschenswert, eine Möglichkeit anzugeben, einen kritischen Batteriezustands auch nach dem Rücksetzen der Batterieüberwachungsvorrichtung erkennen zu können.

### Offenbarung der Erfindung

Erfindungsgemäß wird ein Verfahren zum Erkennen eines kritischen Batteriezustands nach einem Rücksetzen einer Batterieüberwachungsvorrichtung mit den Merkmalen des Patentanspruchs 1 vorgeschlagen. Eine erfinderungsgemäße Batterieüberwachungsvorrichtung wird in Anspruch 7 definiert. Vorteilhafte Ausgestaltungen sind Gegenstand der Unteransprüche sowie der nachfolgenden Beschreibung.

### Vorteile der Erfindung

Erfindungsgemäß wird ein nicht-flüchtiger Speicher verwendet, um ein Datum aufzunehmen, das einen kritischen Batteriezustand kennzeichnet. Die Daten in dem nicht-flüchtigen Speicher überdauern auch ein Rücksetzen der Batterieüberwachungsvorrichtung und stehen so sofort nach dem Rücksetzen zur Verfügung. Die Erfindung bietet somit die Möglichkeit, einen kritischen Batteriezustand auch nach einem Rücksetzen der Batterieüberwachungsvorrichtung zu erkennen, selbst wenn zu diesem Zeitpunkt das auf den reinen Messwerten basierende Ergebnis verfälscht ist. Nach dem Rücksetzen wird deshalb das einen kritischen Batteriezustand kennzeichnende Datum für die Plausibilisierung des Messergebnisses verwendet. Ist das Datum im Speicher vorhanden, wird vorzugsweise jegliche EEM-Funktion deaktiviert, die ein Liegenbleiben des Fahrzeugs verursachen könnte, wie z.B. Start/Stopp-Betrieb, Rekuperation usw. Ein Liegenbleiben des Fahrzeugs wird dadurch vermieden. Nachdem die Batterieüberwachungsvorrichtung eine Rekalibrierung des internen Batteriemodells durchgeführt hat, können alle Funktionen wieder entsprechend dem bestimmten Batteriezustand aktiviert werden. Hinsichtlich Möglichkeiten zur Batteriezustandserkennung sei auf die einleitend genannte DE 101 06 508 A1 sowie den darin genannten Stand der Technik verwiesen.

Ein kritischer Betriebszustand wird zweckmäßigerweise erkannt, wenn der Ladezustand einen ersten Schwellwert, bspw. 40%, unterschreitet. Ein unkritischer Betriebszustand wird zweckmäßigerweise erkannt, wenn der Ladezustand einen zweiten Schwellwert, bspw. 60%, überschreitet, wobei der zweite Schwellwert größer als der erste Schwellwert ist. Alternativ oder zusätzlich können auch andere Kenngrößen des Batteriezustands verwendet werden, wie beispielsweise "State of Function" (SOF), "State of Health" (SOH) oder der zeitliche Verlauf von Strom, Spannung und Temperatur.

Ein kritischer Batteriezustand wird zweckmäßigerweise sofort oder zumindest zeitnah innerhalb weniger Sekunden gespeichert. Wird zu einem späteren Zeitpunkt wieder ein unkritischer Batteriezustand erkannt, kann das Datum wieder aus dem Speicher gelöscht werden. Der Abstand zwischen Erkennung und Speicherung sollte zweckmäßigerweise eine Minute nicht überschreiten. Je länger gewartet wird, desto höher ist das Risiko, die gewonnene Information bspw. wegen Stromausfalls zu verlieren.

In Abhängigkeit vom eingesetzten nicht-flüchtigen Speicher kann es vorkommen, dass nur eine begrenzte Anzahl von Schreibzyklen zur Verfügung steht. Besonders in diesem Fall ist es vorteilhaft, Zustandsdaten insbesondere nur dann zu speichern, wenn ein kritischer Batteriezustand vorliegt, der beispielsweise zum Verlust der Startfähigkeit führen könnte. Auch das Löschen des Datums kann verschoben werden, um Zugriffe einzusparen. Bei Erkennen eines unkritischen Zustands muss das Datum insbesondere nicht sofort gelöscht werden, da diese Zustandsänderung nicht kritisch ist. Es bietet sich an, das Datum bspw. im Rahmen eines ohnehin anstehenden Zugriffs auf den nicht-flüchtigen Speicher zu löschen, wozu sich besonders ein regelmäßiger Zugriff anbietet.

Auch ein Wechsel der kritischen Batterie wirkt sich nicht nachteilig aus. Zwar erkennt die Batterieüberwachungsvorrichtung dann nach dem Rücksetzen anhand des gespeicherten Datums - möglicherweise zu Unrecht - einen kritischen Batteriezustand. Jedoch kalibriert sich die Batterieüberwachungsvorrichtung nach einer gewissen Laufzeit selbständig, so dass dann das Datum wieder gelöscht wird. Als Verbesserung wird vorgeschlagen, bei einem Batteriewechsel das gespeicherte Datum, z.B. über eine neue Batteriekodierung, zweckmäßigerweise durch die ausführende Werkstatt, wieder zu löschen. Allgemein sei jedoch angemerkt, dass ein fälschlicherweise erkannter kritischer Batteriezustand für den Betrieb des Fahrzeugs unkritisch ist, da lediglich ein Liegenbleiben des Fahrzeugs verursachen könnende Funktionen abgeschaltet werden. Ein nicht erkannter kritischer Batteriezustand kann hingegen dazu führen, dass das Fahrzeug liegenbleibt, was für den Fahrer mit besonderen Unannehmlichkeiten verbunden ist.

Vorzugsweise wird ein nicht-flüchtiger Speicher innerhalb der Batterieüberwachungsvorrichtung verwendet, um den Verkabelungs- und Verbindungsaufwand gering zu halten. Besonders vorteilhaft kann ein ohnehin vorhandener Speicher verwendet werden, so dass eine Implementierung der Erfindung auch in bestehenden Batterieüberwachungsvorrichtungen möglich ist. Beispielsweise umfasst der von der Anmelderin angebotene EBS bereits eine NVM-Einheit (engl.: non volatile memory, nicht-flüchtiger Speicher), die zur Aufnahme des Datums geeignet ist. Es versteht sich jedoch, dass ein den kritischen Batteriezustand anzeigendes Signal auch außerhalb der Batterieüberwachungsvorrichtung verarbeitet werden kann, bspw. zur Speicherung in einem anderen Steuergerät.

Eine erfindungsgemäße Batterieüberwachungsvorrichtung umfasst eine Recheneinheit, die programmtechnisch dazu eingerichtet ist, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung ausführlich beschrieben.

### Kurze Beschreibung der Zeichnung

Figur 1 zeigt eine bevorzugte Ausführungsform einer erfindungsgemäßen Batterieüberwachungsvorrichtung in einem Energieversorgungssystem eines Kraftfahrzeugs.
Figur 2 zeigt eine bevorzugte Ausführungsform eines erfindungsgemäßen Verfahrens anhand einer Darstellung als Zustandsautomat.

### Ausführungsform(en) der Erfindung

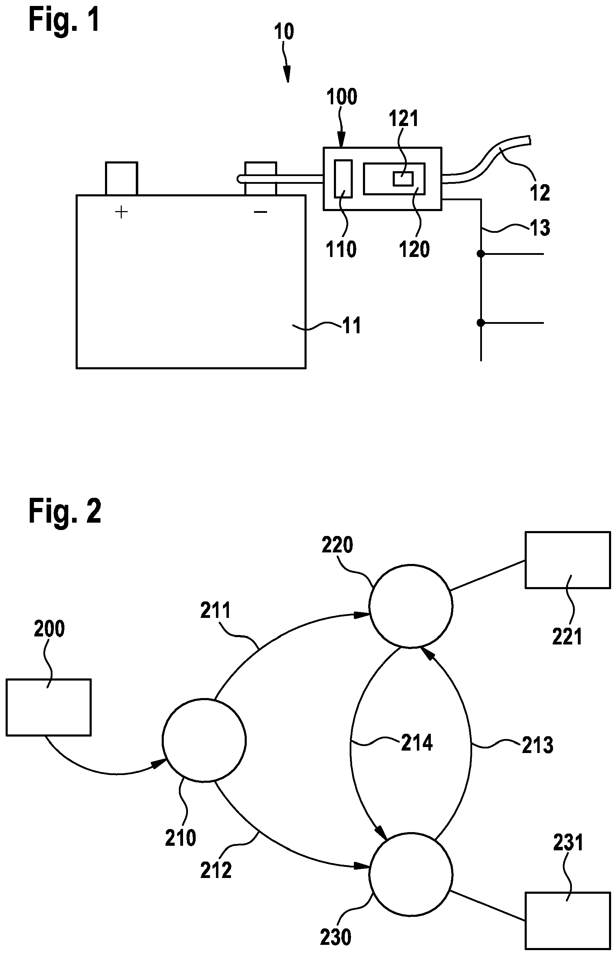

In Figur 1 ist eine bevorzugte Ausführungsform 100 einer erfindungsgemäßen Batterieüberwachungsvorrichtung schematisch innerhalb eines Energieversorgungssystems 10 eines Kraftfahrzeugs dargestellt. Die Batterieüberwachungsvorrichtung 100 ist zwischen einem Minuspol einer Starterbatterie 11 und einem Batteriekabel 12 des Kraftfahrzeugs angeschlossen.

Die Batterieüberwachungsvorrichtung 100 umfasst einen Messteil 110, der eine Reihe von Größen der Batterie 11 misst. Weiterhin umfasst die Batterieüberwachungsvorrichtung 100 eine Recheneinheit 120 zur Auswertung der gemessenen Größen und zur Bestimmung eines Batteriezustands. Die Recheneinheit 120 verfügt über einen nicht-flüchtigen Speicher 121 zur Aufnahme u.a. eines einen kritischen Batteriezustand kennzeichnenden Datums. Die Batterieüberwachungsvorrichtung 100 ist über eine Verbindung 13, insbesondere eine Bus-Verbindung, mit weiteren Bestandteilen des Fahrzeugs, insbesondere Steuergeräten, verbunden.

In Figur 2 ist eine bevorzugte Ausführungsform der Erfindung in Form eines Zustandsautomaten dargestellt. Die Erfindung wird unter Bezugnahme auf die Batterieüberwachungsvorrichtung 100 gemäß Figur 1 beschrieben.

Ausgehend von einem Rücksetzten 200 der Batterieüberwachungsvorrichtung 100, was beispielsweise durch einen Verlust der Versorgungsspannung hervorgerufen sein kann, geht die Batterieüberwachungsvorrichtung 100 (nachfolgend als System bezeichnet) zunächst in einen Initialisierungszustand 210 über. Dort wird überprüft, ob in dem nicht-flüchtigen Speicher 121 ein einen kritischen Zustand kennzeichnendes Datum gespeichert ist. Ist dies der Fall, geht das System entlang der Verbindung 211 in einen Zustand 220 über, der durch das Erkennen eines kritischen Batteriezustands definiert ist.

Wird hingegen in Zustand 210 festgestellt, dass das den kritischen Batteriezustand kennzeichnende Datum nicht in dem Speicher 121 gespeichert ist, wechselt das System entlang einer Verbindung 212 in den Zustand 230, der durch das Erkennen eines unkritischen Batteriezustands gekennzeichnet ist.

Befindet sich das System im Zustand 220, wird das den kritischen Batteriezustand kennzeichnende Datum gemäß 221 sofort, d.h. vorzugsweise innerhalb einer oder weniger Sekunden, in dem nicht-flüchtigen Speicher 121 gespeichert. Weiterhin werden startfähigkeitsrelevante EEM-Funktionen deaktiviert.

Befindet sich das System in dem Zustand 230, wird ein gegebenenfalls in dem nicht-flüchtigen Speicher 121 vorhandenes Datum gemäß 231 im Rahmen eines ohnehin stattfindenden Speicherzugriffs, beispielsweise im Rahmen eines regelmäßigen Speicherzyklus, gelöscht. Weiterhin werden startfähigkeitsrelevante EEM-Funktionen aktiviert.

Der Übergang zwischen den Zuständen 220 und 230 findet entlang der Verbindungen 213 und 214 statt. Befindet sich das System im Zustand 230 und wird ein kritischer Batteriezustand festgestellt, weil beispielsweise der Batterieladezustand einen ersten Schwellwert von 40% unterschreitet, wechselt das System entlang 213 in den Zustand 220.

Befindet sich das System im Zustand 220 und wird ein unkritischer Batteriezustand festgestellt, weil beispielsweise der Batterieladezustand einen zweiten Schwellwert von 60% überschreitet, wechselt das System entlang 214 in den Zustand 230. Eine Schwellwertüberschreitung kann bspw. auch bei einer Rekalibrierung des Sensors erkannt werden.

Im Rahmen der Erfindung kann damit eine einfache und zuverlässige Lösung bereitgestellt werden, einen kritischen Batteriezustand auch nach einem Rücksetzen der Batterieüberwachungsvorrichtung zu erkennen.

## Patentansprüche

1. Verfahren zum Erkennen eines kritischen Batteriezustands nach einem Rücksetzen einer Batterieüberwachungsvorrichtung (100), wobei in einem nicht-flüchtigen Speicher (121) ein den kritischen Batteriezustand anzeigendes Datum gespeichert wird (221), wenn von der Batterieüberwachungsvorrichtung (100) ein kritischer Batteriezustand erkannt wird (220), und nach dem Rücksetzen (200) der Batterieüberwachungsvorrichtung ein kritischer Batteriezustand erkannt wird (211, 220), wenn das den kritischen Batteriezustand anzeigende Datum in dem nicht-flüchtigen Speicher (121) gespeichert ist,
**dadurch gekennzeichnet, dass**
das den kritischen Batteriezustand anzeigende Datum bei einem ohnehin vorgesehenen Speicherzugriff aus dem nicht-flüchtigen Speicher (121) gelöscht wird (231), wenn ein unkritischer Batteriezustand erkant wird.

2. Verfahren nach Anspruch 1, wobei ein kritischer Batteriezustand erkannt wird (220), wenn ein den Batteriezustand kennzeichnender Wert, insbesondere ein Ladezustand, einen ersten Schwellwert unterschreitet.

3. Verfahren nach Anspruch 1 oder 2, wobei ein unkritischer Batteriezustand erkannt wird (230), wenn ein den Batteriezustand kennzeichnender Wert, insbesondere ein Ladezustand, einen zweiten Schwellwert überschreitet.

4. Verfahren nach einem der vorstehenden Ansprüche, wobei ein Liegenbleiben des Fahrzeugs verursachen könnende Funktionen deaktiviert werden (221), wenn ein kritischer Batteriezustand erkannt wird (220).

5. Verfahren nach Anspruch 4, wobei ein Liegenbleiben des Fahrzeugs verursachen könnende Funktionen deaktiviert werden (221), wenn nach dem Rücksetzen (200) der Batterieüberwachungsvorrichtung ein kritischer Batteriezustand erkannt wird (211, 220).

6. Verfahren nach einem der vorstehenden Ansprüche, wobei das den kritischen Batteriezustand anzeigende Datum sofort oder zeitnah, insbesondere innerhalb einer, zehn, dreißig oder sechzig Sekunden, in dem nicht-flüchtigen Speicher (121) gespeichert wird (221), wenn von der Batterieüberwachungsvorrichtung (100) ein kritischer Batteriezustand erkannt wird (220).

7. Batterieüberwachungsvorrichtung (100) mit einer Recheneinheit (120), die dazu eingerichtet ist, ein Verfahren nach einem der vorstehenden Ansprüche durchzuführen, und mit einem integrierten nicht-flüchtigen Speicher (121) zur Aufnahme des den kritischen Batteriezustand anzeigenden Datums.

## Claims

1. Method for recognizing a critical battery state after resetting a battery monitoring device (100), wherein a datum that indicates the critical battery state is stored (221) in a non-volatile memory (121) if the battery monitoring device (100) recognizes (220) a critical battery state, and after resetting (200) the battery monitoring device a critical battery state is recognized (211, 220), if the datum that indicates the critical battery state is stored in the non-volatile memory (121), **characterized in that**, if a non-critical battery state is recognized, the datum that indicates the critical battery state is deleted (231) from the non-volatile memory (121) within the scope of a memory access that already takes place.

2. Method according to Claim 1, wherein a critical battery state is recognized (220) if a value that characterizes the battery state, in particular a state of charge, is below a first threshold value.

3. Method according to Claim 1 or 2, wherein a non-critical battery state is recognized (230) if a value that characterizes the battery state, in particular a state of charge, exceeds a second threshold value.

4. Method according to any one of the preceding claims, wherein functions that could cause the vehicle to fail to start are deactivated (221) if a critical battery state is recognized (220).

5. Method according to Claim 4, wherein functions that could cause the vehicle to fail to start are deactivated (221) if a critical battery state is recognized (211, 220) after resetting (200) the battery monitoring device.

6. Method according to any one of the preceding claims, wherein the datum that indicates the critical battery state is stored (221) in the non-volatile memory (121) immediately or promptly, in particular within one, ten, thirty or sixty seconds, if the battery monitoring device (100) recognizes (220) a critical battery state.

7. Battery monitoring device (100) having a data processing unit (120) that is equipped for the purpose of performing a method according to any one of the preceding claims and having an integrated non-volatile memory (121) for storing the datum that indicates the critical battery state.

## Revendications

1. Procédé de détection d'un état critique d'une batterie après la remise en service d'un ensemble (100) de surveillance de batterie, une donnée indiquant que l'état de la batterie est critique étant conservée en mémoire (221) dans une mémoire non volatile (121) si l'ensemble (100) de surveillance de batterie détecte (220) que l'état de la batterie est critique, et après la remise en service (200) de l'ensemble de surveillance de batterie, un état critique (211, 220) de la batterie est détecté si la donnée indiquant que l'état de la batterie est critique a été conservée dans mémoire non volatile (121),
**caractérisé en ce que**
la donnée indiquant que l'état de la batterie est critique est effacée (231) de la mémoire non volatile (121) lors d'un accès de toute manière prévu à la mémoire si l'état de la batterie détecté n'est pas critique.

2. Procédé selon la revendication 1, dans lequel un état critique de la batterie est détecté (220) si une valeur qui caractérise l'état de la batterie, en particulier l'état de sa charge, n'atteint pas une première valeur de seuil.

3. Procédé selon les revendications 1 ou 2, dans lequel un état non critique de la batterie est détecté (230) si une valeur qui caractérise l'état de la batterie, en particulier l'état de sa charge, dépasse une deuxième valeur de seuil.

4. Procédé selon l'une des revendications précédentes, dans lequel des fonctions pouvant déclencher une mise à l'arrêt du véhicule sont désactivées (221) lorsqu'un état critique de la batterie est détecté (220).

5. Procédé selon la revendication 4, dans lequel des fonctions pouvant déclencher une mise à l'arrêt du véhicule sont désactivées (221) si après la remise en service (200) de l'ensemble de surveillance de batterie un état critique de la batterie est détecté (211, 220).

6. Procédé selon l'une des revendications précédentes, dans lequel la donnée indiquant que l'état de la batterie est critique est conservée (221) dans la mémoire non volatile (121) immédiatement ou presque et en particulier en moins d'une, dix, trente ou soixante secondes, si un état critique de la batterie est détecté (220) par l'ensemble (100) de surveillance de batterie.

7. Ensemble (100) de surveillance de batterie doté d'une unité de calcul (120) conçue pour mettre en oeuvre un procédé selon l'une des revendications précédentes et d'une mémoire non volatile intégrée (121) qui reprend indiquant que l'état de la batterie est critique.
